# EUROPÄISCHE PATENTANMELDUNG

(11) **EP 3 822 035 A1**
(43) Veröffentlichungstag der Anmeldung: **19.05.2021**
(21) Anmeldenummer: 19209161.9
(22) Anmeldetag: 14.11.2019
(51) Int. Cl.: B25D 17/04, B25F 5/00, H03K 17/97, H01H 9/06

(54) **HANDGRIFFVORRICHTUNG FÜR EINE WERKZEUGMASCHINE**

(71) Anmelder: Hilti Aktiengesellschaft, 9494 Schaan (LI)
(72) Erfinder: Ringler, Stefan, 86853 Schwabmühlhausen (DE); Geiger, Steffen, 80686 München (DE)
(74) Vertreter: Hilti Aktiengesellschaft Corporate Intellectual Property

(57) **Zusammenfassung**

Handgriffvorrichtung an einer Werkzeugmaschine, insbesondere Meißelhammer, mit einem Antrieb, einer Steuerungseinrichtung, einer Übertragungseinrichtung, wobei die Handgriffvorrichtung ein Hebelelement enthält, welches relativ zu einem Gehäuse der Werkzeugmaschine schwenkbar ist.

Das Hebelelement ist durch Ausüben einer Kraft in eine Richtung relativ zu dem Gehäuse der Werkzeugmaschine reversibel bewegbar und eine Sensoreinrichtung ist enthalten zum Erfassen wenigstens einer ersten oder zweiten Position des Hebelelements relativ zu dem Gehäuse der Werkzeugmaschine, wobei eine erste Drehzahl für den Antrieb eingestellt wird, wenn die erste Position des Hebelelements relativ zu dem Gehäuse der Werkzeugmaschine erfasst wird und eine zweite Drehzahl für den Antrieb eingestellt wird, wenn die zweite Position des Hebelelements relativ zu dem Gehäuse der Werkzeugmaschine erfasst wird.

## Beschreibung

### Handgriffvorrichtung für eine Werkzeugmaschine

Die vorliegende Erfindung betrifft eine Handgriffvorrichtung an einer Werkzeugmaschine, insbesondere Meißelhammer, mit einem Antrieb, einer Steuerungseinrichtung, einer Übertragungseinrichtung, wobei die Handgriffvorrichtung ein Hebelelement enthält, welches relativ zu einem Gehäuse der Werkzeugmaschine schwenkbar ist.

Ein Meißelhammer gemäß dem Stand der Technik wird zum Bearbeiten (d.h. Aufreißen, Abbrechen oder Meißeln) von mineralischen Werkstoffen, wie beispielsweise Beton, Ziegel oder dergleichen verwendet. Der Meißelhammer kann auch als Abbruch-, Abbau- oder Aufbrechhammer bezeichnet werden. Der Meißelhammer verfügt über einen Antrieb, der mit Hilfe eines Übertragungsmechanismus Schläge auf ein Meißelwerkzeug (auch Meißel genannt) überträgt. Bei dem Antrieb kann es sich um einen Elektromotor oder Verbrennungsmotor handeln.

Für gewöhnlich weist der Meißelhammer zwei Handgriffe auf, welche an gegenüberliegenden Seiten des Gehäuses des Meißelhammers positioniert sind. Wenigstens einer der beiden Handgriffe umfasst einen Aktivierungsschalter, mit dem der Meißelhammer aktiviert bzw. eingeschaltet werden kann. Die Handgriffe erstrecken sich dabei meistens in einem stumpfen Winkel zu einer Längsachse des Gehäuses des Meißelhammers. Zur Verwendung des Meißelhammers wird der Aktivierungsschalter gedrückt und der Meißelhammer wird aktiviert, sodass Schläge von dem Antrieb auf den Meißel übertragen werden.

Ein Problem bei einem Meißelhammer gemäß dem Stand der Technik besteht darin, dass nach der Aktivierung (d.h. Einschalten) des Meißelhammers für gewöhnlich der Antrieb mit einer maximalen Drehzahl und folglich der Meißelhammer mit voller Leistung betrieben wird. Wenn ein Anwender den Meißelhammer zu diesem Zeitpunkt noch nicht in einem ausreichenden Masse kontrolliert, d.h. der Anwender noch nicht beide Hände an den jeweiligen Handgriffen positioniert hat und den Meißelhammer festhält, ist der Meißelhammer unzureichend geführt und ein adäquates sowie sicheres Arbeiten ist nicht möglich.

Es ist somit Aufgabe der vorliegenden Erfindung das vorstehend erwähnte Problem zu lösen und eine Handgriffvorrichtung an einer Werkzeugmaschine, insbesondere an einem Meißelhammer, bereitzustellen, welche ein einfaches sowie sicheres Arbeiten mit einer Werkzeugmaschine, insbesondere mit einem Meißelhammer, ermöglicht.

Die Aufgabe wird gelöst durch den Gegenstand in Anspruch 1 bzw. durch den Gegenstand in Anspruch 4. Vorteilhafte Ausführungsformen sind in den Unteransprüchen aufgeführt.

Die Aufgabe wird dabei gelöst durch eine Handgriffvorrichtung an einer Werkzeugmaschine, insbesondere Meißelhammer, mit einem Antrieb, einer Steuerungseinrichtung, einer Übertragungseinrichtung, wobei die Handgriffvorrichtung ein Hebelelement enthält, welches relativ zu einem Gehäuse der Werkzeugmaschine schwenkbar ist.

Erfindungsgemäß ist vorgesehen, dass das Hebelelement durch Ausüben einer Kraft in eine Richtung relativ zu dem Gehäuse der Werkzeugmaschine reversibel bewegbar ist und eine Sensoreinrichtung enthalten ist zum Erfassen wenigstens einer ersten oder zweiten Position des Hebelelements relativ zu dem Gehäuse der Werkzeugmaschine, wobei eine erste Drehzahl für den Antrieb eingestellt wird, wenn die erste Position des Hebelelements relativ zu dem Gehäuse der Werkzeugmaschine erfasst wird und eine zweite Drehzahl für den Antrieb eingestellt wird, wenn die zweite Position des Hebelelements relativ zu dem Gehäuse der Werkzeugmaschine erfasst wird.

Der zweite Drehzahlwert ist dabei höher als der erste Drehzahlwert. Der Antrieb kann dabei als Elektromotor ausgestaltet sein. Bei der Ausgestaltung der Werkzeugmaschine als Meißelhammer kann die Übertragungseinrichtung als Schlagwerkseinrichtung gestaltet sein. Mit Hilfe eines hohen Drehzahlwertes kann durch eine Kombination von dem als Elektromotor ausgestalteten Antrieb mit der als Schlagwerkseinrichtung ausgestalteten Übertragungseinrichtung eine hohe Schlagenergie auf ein als Meißel ausgestaltetes Werkzeug erzeugt werden.

Entsprechend einer vorteilhaften Ausgestaltung der vorliegenden Erfindung kann es möglich sein, dass das Hebelelement ein Signalgeber mit wenigstens einem Magneten enthält und die Sensoreinrichtung wenigstens einen ersten sowie zweiten Hall-Sensor zum Erfassen des wenigstens einen Magneten enthält, wobei der Signalgeber relativ zu der Sensoreinrichtung reversibel bewegbar ist.

Gemäß einer vorteilhaften Ausgestaltung der vorliegenden Erfindung kann es möglich sein, dass eine separat zu betätigende Einschalteinrichtung an der Werkzeugmaschine enthalten ist. Durch die Einschalteinrichtung kann wenigstens der Antrieb der Werkzeugmaschine aktiviert werden. Die Aktivierung der Übertragungseinrichtung erfolgt dabei nicht mit Hilfe der Einschalteinrichtung.

Weitere Vorteile ergeben sich aus der folgenden Figurenbeschreibung. In den Figuren sind verschiedene Ausführungsbeispiele der vorliegenden Erfindung dargestellt. Die Figuren, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

In den Figuren sind gleiche und gleichartige Komponenten mit gleichen Bezugszeichen beziffert. Es zeigen:
- Figur 1: eine schematische Vorderansicht auf eine erfindungsgemäße Werkzeugmaschine in Form eines Meißelhammers mit einer erfindungsgemäßen Handgriffvorrichtung;
- Figur 2a: eine Detailansicht auf die Handgriffvorrichtung in einer ersten Positionierung gemäß einem ersten Ausführungsbeispiel;
- Figur 2b: eine Detailansicht auf die Handgriffvorrichtung in einer zweiten Positionierung gemäß dem ersten Ausführungsbeispiel;
- Figur 2c: eine Detailansicht auf die Handgriffvorrichtung in einer dritten Positionierung gemäß dem ersten Ausführungsbeispiel;
- Figur 3a: eine Detailansicht auf die Handgriffvorrichtung in einer ersten Positionierung gemäß einem zweiten Ausführungsbeispiel;
- Figur 3b: eine Detailansicht auf die Handgriffvorrichtung in einer zweiten Positionierung gemäß dem zweiten Ausführungsbeispiel; und
- Figur 3c: eine Detailansicht auf die Handgriffvorrichtung in einer dritten Positionierung gemäß dem zweiten Ausführungsbeispiel.

### Ausführungsbeispiele:

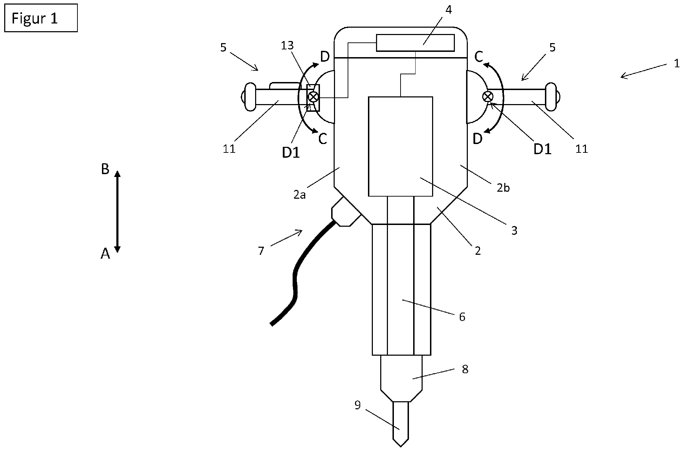

Figur 1 zeigt eine erfindungsgemäße Werkzeugmaschine 1 in Form eines Meißelhammers. Die Werkzeugmaschine 1 kann jedoch auch in Form eines Bohrhammers, einer Bohrmaschine, einer Säge, eines Schleifgeräts oder dergleichen ausgestaltet sein.

Wie in Figur 1 angedeutet, enthält die als Meißelhammer ausgestaltete Werkzeugmaschine 1 im Wesentlichen ein Gehäuse 2, einen Antrieb 3, eine Steuerungseinrichtung 4, eine erste und zweite Handgriffvorrichtung 5, eine Übertragungseinrichtung 6, eine Energieversorgungseinrichtung 7 sowie eine Werkzeugaufnahme 8.

Im Inneren des Gehäuses ist im Wesentlichen der Antrieb 3, die Steuerungseinrichtung 4 und die Übertragungseinrichtung 6 positioniert. Der Antrieb 3 ist dabei als Elektromotor ausgestaltet. Bei dem Elektromotor kann es sich um einen bürstenlosen Elektromotor handeln.

An einem unteren Ende des Gehäuses 2 der Werkzeugmaschine 1 ist die Werkzeugaufnahme 8 positioniert. Mit Hilfe der Werkzeugaufnahme 8 kann ein Werkzeug 9 aufgenommen und gehalten werden. In den Figuren ist das Werkzeug 9 als Meißel ausgestaltet.

Darüber hinaus ist an der ersten Seitenwand 2a des Gehäuses 2 der Werkzeugmaschine 1 die Energieversorgungseinrichtung 7 vorgesehen. In dem angeführten Beispiel der Werkzeugmaschine 1 handelt sich bei der Energieversorgungseinrichtung 7 um ein Stromnetzanschluss sowie um ein Stromnetzkabel. Ein freies Ende des Stromnetzkabels kann mit einem Stromnetzanschluss (auch Steckdose genannt) verbunden werden. Mit Hilfe der Energieversorgungseinrichtung 7 kann die Werkzeugmaschine 1 und insbesondere der als Elektromotor ausgestaltete Antrieb 3 mit Energie, beispielsweise mit elektrischer Energie, versorgt werden.

Entsprechend einer alternativen Ausgestaltungsform der erfindungsmäßen Werkzeugmaschine 1 kann die Energieversorgungseinrichtung 7 auch als ein einziger Akkumulator oder als mehrere Akkumulatoren ausgestaltet sein: Mit Hilfe einer oder mehreren Akku-Schnittstellen ist der einzelne oder mehrere Akkumulatoren an oder in dem Gehäuse 2 der Werkzeugmaschine 1 positioniert.

Wie bereits vorstehend erwähnt ist der Antrieb 3 in der vorliegenden Ausgestaltungsform der Werkzeugmaschine 1 als Elektromotor ausgestaltet. Alternativ kann es sich bei dem Antrieb 3 auch um einen Verbrennungsmotor handeln. In diesem Falle ist die Energieversorgungseinrichtung 7 als Treibstofftank ausgestaltet.

Gemäß einer weiteren alternativen Ausgestaltungsform der erfindungsgemäßen Werkzeugmaschine 1 kann der Antrieb 3 auch in Form eines pneumatischen Antriebs bzw. Kompressors ausgestaltet sein. Bei der Energieversorgungseinrichtung 7 kann es sich in diesem Fall um einen Druckluftanschluss oder Druckluftvorrat an oder in der Werkzeugmaschine 1 handeln.

Der als Elektromotor ausgestaltete Antrieb 3 dient zum Erzeugen eines Drehmoments. Mit Hilfe der Übertragungseinrichtung 6 kann das vom Antrieb 3 erzeugte Drehmoment in Form von (Hammer-)Schlägen auf die Werkzeugaufnahme 8 und schließlich auf das als Meißel ausgestaltete Werkzeug 9 übertragen werden. Die Übertragungseinrichtung 6 kann auch als Schlagwerk bezeichnet werden. Je höher die Frequenz der Schläge, desto mehr Schlagenergie wird erzeugt.

Die Steuerungseinrichtung 4 ist mit der ersten und zweiten Handgriffvorrichtung 5 sowie mit dem Antrieb 3 verbunden. Signale und Kommunikationsdaten können somit zwischen den Handgriffvorrichtungen 5, dem Antrieb 3 und der Steuerungseinrichtung 4 gesendet und empfangen werden. Die Steuerungseinrichtung 4 dient zum Steuern und Regeln der unterschiedlichen Funktionen der Werkzeugmaschine 1 sowie insbesondere zum Einstellen der Parameter bzw. Betriebsparameter des Antriebs 3. Mit Hilfe der Steuerungseinrichtung 4 kann damit speziell die Drehzahl des als Elektromotors ausgestalten Antriebs 3 als Parameter bzw. Betriebsparameter eingestellt werden.

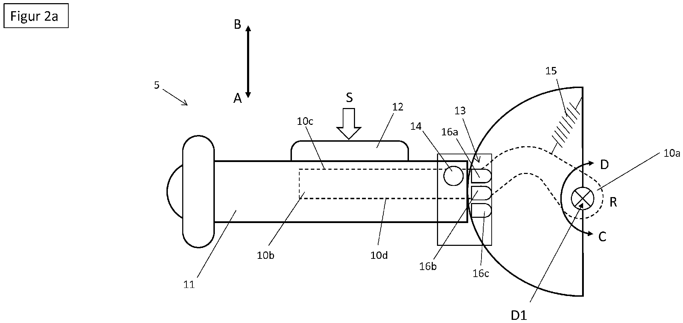

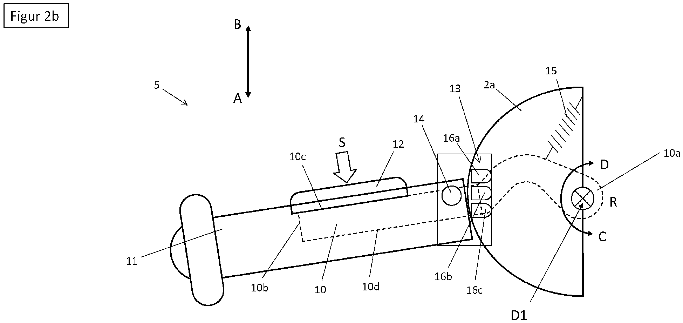

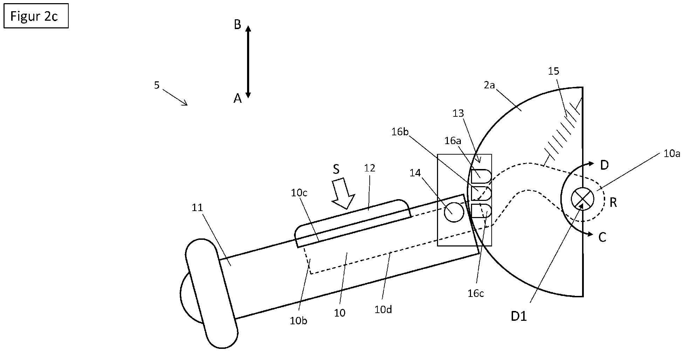

Die erste Handgriffvorrichtung 5 ist bewegbar an einer ersten Seitenwand 2a des Gehäuses 2 und die zweite Handgriffvorrichtung 5 ist bewegbar an einer zweiten Seitenwand 2b des Gehäuses 2 positioniert. Wie in Figur 1 und 2 gezeigt enthält sowohl die erste als auch die zweite Handgriffvorrichtung 5 jeweils ein Hebelelement 10 und ein Griffstück 11. Das jeweilige Hebelelement 10 der ersten und zweiten Handgriffvorrichtung 5 ist entsprechend über einen entsprechenden ersten Drehpunkt D1 in Drehrichtung C oder D schwenkbar gelagert. Die erste und zweite Handgriffvorrichtung 5 dient zum Halten und Führen der Werkzeugmaschine 1 durch einen Anwender. Der Anwender ist in den Figuren nicht gezeigt.

In den Figuren 2a bis 2c ist die erfindungsgemäße Handgriffvorrichtung 5 in Form eines ersten Ausführungsbeispiels dargestellt. Die Handgriffvorrichtung 5 gemäß dem ersten Ausführungsbeispiel enthält dabei im Wesentlichen ein Hebelelement 10, ein Griffstück 11, ein Aktivierungselement 12, eine Sensoreinrichtung 13 sowie einen Signalgeber 14.

Das als Betätigungsschalter ausgestaltete Aktivierungselement 12 dient zum Aktivieren des Antriebs 3 der Werkzeugmaschine 1. Das Aktivierungselement 12 kann durch Ausüben einer Kraft in Richtung S reversibel von einer ersten Position in eine zweite Position gebracht wird. In Figur 2a ist das Aktivierungselement 12 in der ersten Position, d.h. in einem nicht gedrückten Zustand, gezeigt. Die erste Position entspricht dabei der obersten Position. Die Aktivierung des Antriebs 3 erfolgt sobald das Aktivierungselement 12 von der ersten Position in die zweite Position wegbewegt wird. In Figur 2b und 2c ist das Aktivierungselement 12 jeweils in der zweiten Position, d.h. in einem gedrückten Zustand, dargestellt. Das Aktivierungselement 12 ist so mit der Steuerungseinrichtung 4 verbunden, dass Signale zwischen dem Aktivierungselement 12 und der Steuerungseinrichtung 4 ausgetauscht werden können. Die Verbindung zwischen dem Aktivierungselement 12 und der Steuerungseinrichtung 4 ist in den Figuren nicht dargestellt. Die jeweilige Position, d.h. die erste oder zweite Position, des Aktivierungselements 12 wird an die Steuerungseinrichtung 4 mit Hilfe eines entsprechenden Signals übermittelt. Wenn das Aktivierungselement 12 sich in der zweiten Position befindet, ist lediglich der Antrieb 3 der Werkzeugmaschine 1 aktiviert. Die als Schlagwerkeinrichtung ausgestaltete Übertragungseinrichtung 6 wird nicht nur durch das Drücken des Aktivierungselements 12 in Pfeilrichtung S aktiviert bzw. gestartet.

Die Sensoreinrichtung 13 ist so mit der Steuerungseinrichtung 4, dass Signale, Daten und Informationen zwischen der Sensoreinrichtung 13 und der Steuerungseinrichtung 4 ausgetauscht werden können.

Das Hebelelement 10 ist im Wesentlichen als länglicher Hebelarm mit einem ersten Ende 10a und zweiten Ende 10b sowie mit einer Ober- und Unterseite 10c, 10d ausgestaltet. Das Hebelelement 10 ist mit dem ersten Ende 10a über einen ersten Drehpunkt D1 in eine Drehrichtung C oder D reversibel schwenkbar zu dem Gehäuse 2 der Werkzeugmaschine 1 montiert. Wenn eine Kraft in Richtung A auf die Oberseite 10c des Hebelelements 10 ausgeübt wird, schwenkt das Hebelelement 10 um den Drehpunkt D1 in Drehrichtung C. Wenn keine Kraft mehr auf die Oberseite 10c des Hebelelements 10 ausgeübt wird, schwenkt das Hebelelement 10 um den ersten Drehpunkt D1 mit Hilfe eines ersten Federelements 15 in Drehrichtung D in die Ausgangsposition zurück. Das erste Federelement 15 kann dabei in Form einer Spiralfeder oder Drehstabfeder ausgestaltet sein.

Der Signalgeber 14 ist fest mit dem Hebelelement 10 verbunden und in Form eines Magneten ausgestaltet. Bei dem Magneten kann es sich um einen Permanentmagnet handeln. Wie in den Figuren 2a bis 2c gezeigt ist der als Magnet ausgestaltete Signalgeber 14 am dem Hebelelement 10 positioniert. Durch die Positionierung an dem Hebelelement 10 kann der Signalgeber 14 relativ zu dem Gehäuse 2 der Werkzeugmaschine 1 bewegt werden.

Die Sensoreinrichtung 13 ist an der ersten Seitenwand 2a des Gehäuses 2 der Werkzeugmaschine 1 positioniert und enthält im Wesentlichen einen ersten, zweiten und dritten Hall-Sensor 16a, 16b, 16c. Wie in den Figuren 2a bis 2c gezeigt, sind die drei Hall-Sensoren 16a, 16b, 16c untereinander in Richtung A an dem Gehäuse 2 der Werkzeugmaschine 1 positioniert. Die Hall-Sensoren 16a, 16b, 16c sind so an dem Gehäuse 2 der Werkzeugmaschine 1 positioniert, dass stets wenigstens einer der drei Hall-Sensoren 16a, 16b, 16c die Position des als Magneten ausgestalteten Signalgebers 14 detektieren kann, wenn das Hebelelement 10 in Drehrichtung C oder D geschwenkt wird.

Gemäß einer alternativen (in den Figuren nicht gezeigten) Ausgestaltungsform können auch mehr oder weniger als drei Hall-Sensoren vorgesehen sein. Entsprechend einer weiteren alternativen Ausgestaltungsform können anstelle der Hall-Sensoren 16a, 16b, 16c auch durch 3D-Sensoren, TOF-Kameras (= Time Of Flight Kameras) und/oder PMD-Sensoren (= Photomischdetektoren) verwendet werden.

Wie bereits vorstehend erwähnt, ist in Figur 2a das Aktivierungselement 12 nicht in Richtung A gedrückt und die Handgriffvorrichtung 5 ist nicht durch Ausüben einer Kraft in Richtung C geschwenkt. Der erste (d.h. oberste) Hall-Sensor 16a der Sensoreinrichtung 13 erfasst die Nähe des als Magneten ausgestalteten Signalgebers 14. Die Sensoreinrichtung 13 sendet ein entsprechendes Signal an die Steuerungseinrichtung 4, um der Steuerungseinrichtung 4 mitzuteilen, dass keine Kraft auf die Handgriffvorrichtung 5 ausgeübt wird. In diesem Zustand ist weder der Antrieb 3 noch die Übertragungseinrichtung 6 aktiviert. Folglich wird keine Schlagenergie auf das Werkzeug 9 übertragen. Beispielsweise könnte ein Werkzeugwechsel in diesem Zustand sicher vorgenommen werden.

In Figur 2b wird eine erste Kraft in Richtung A auf das Aktivierungselement 12 und die Handgriffvorrichtung 5 ausgeübt. Hierdurch wird das Aktivierungselement 12 von der ersten Position in die zweite Position gebracht. Der Antrieb 3 wird daraufhin aktiviert. Gleichzeitig wird durch das Ausüben der Kraft in Richtung A die Handgriffvorrichtung 5 und damit das Hebelelement 10 um den ersten Drehpunkt D1 in Drehrichtung C geschwenkt. In Figur 2b wird so viel Kraft auf die Handgriffvorrichtung 5 und das Hebelelement 10 ausgeübt, dass sich Handgriffvorrichtung 5 in einer mittleren Position befindet. Der als Magnet ausgestaltete Signalgeber 14 ist dabei so positioniert, dass der zweite (mittlere) Hall-Sensor 16b der Sensoreinrichtung 13 den Magneten erfassen kann. Die Sensoreinrichtung 13 erfasst somit, dass sich die Handgriffvorrichtung 5 in einer mittleren Position befindet. Wenn die Sensoreinrichtung 13 mit Hilfe des zweiten Hall-Sensors 16b die mittlere Position der Handgriffvorrichtung 5 erfasst, wird ein entsprechendes Signal an die Steuerungseinrichtung 4 gesendet. Durch das Signal wird der Steuerungseinrichtung 4 mitgeteilt, dass eine mittlere Kraft von dem Anwender auf die Handgriffvorrichtung 5 ausgeübt wird. Die Steuerungseinrichtung 4 steuert den als Elektromotor ausgestalten Antrieb 3 so an, dass in Abhängigkeit der mittleren Kraftausübung auf die Handgriffvorrichtung 5 eine erste Drehzahl für den Antrieb 3 eingestellt wird. Durch die erste Drehzahl wird ein erster Wert an Schlagenergie von der Übertragungseinrichtung 6 auf das Werkzeug 9 gegeben.

In Figur 2c wird eine zweite Kraft in Richtung A auf die Handgriffvorrichtung 5 ausgeübt. Die zweite Kraft ist dabei größer als die erste Kraft. Wie in Figur 2c ersichtlich befindet sich das Aktivierungselement 12 weiterhin in der zweiten (d.h. gedrückten) Position. Der Antrieb 3 ist durch das Drücken des Aktivierungselements 12 in Richtung S weiterhin aktiviert. Durch das Ausüben der zweiten (d.h. erhöhten) Kraft in Richtung A auf die Handgriffvorrichtung 5 wird das Hebelelement 10 weiter als in Figur 2b in Drehrichtung C geschwenkt. Das Hebelelement 10 wird dabei soweit geschwenkt, dass sich der an dem Hebelelement 10 positionierte Signalgeber 14 auf Höhe des dritten (d.h. tiefsten) Hall-Sensors 16c befindet. Die Sensoreinrichtung 13 erfasst somit, dass maximaler Druck auf die Handgriffvorrichtung 5 ausgeübt wird und sich die Handgriffvorrichtung 5 in einer unteren (d.h. tiefsten) Position befindet. Wenn die Sensoreinrichtung 13 mit Hilfe des dritten Hall-Sensors 16c die unterste Position der Handgriffvorrichtung 5 erfasst, wird ein entsprechendes Signal an die Steuerungseinrichtung 4 gesendet. Durch das Signal wird der Steuerungseinrichtung 4 mitgeteilt, dass eine maximale Kraft von dem Anwender auf die Handgriffvorrichtung 5 ausgeübt wird. Die Steuerungseinrichtung 4 steuert den als Elektromotor ausgestalten Antrieb 3 so an, dass in Abhängigkeit der maximalen Kraftausübung auf die Handgriffvorrichtung 5 eine zweite Drehzahl für den Antrieb 3 eingestellt wird. Der zweite Drehzahlwert ist dabei höher als der erste Drehzahlwert. Durch die zweite Drehzahl wird ein zweiter Wert an Schlagenergie von der Übertragungseinrichtung 6 auf das Werkzeug 9 gegeben. der zweite Wert an Schlagenergie ist höher als der erste Wert an Schlagenergie.

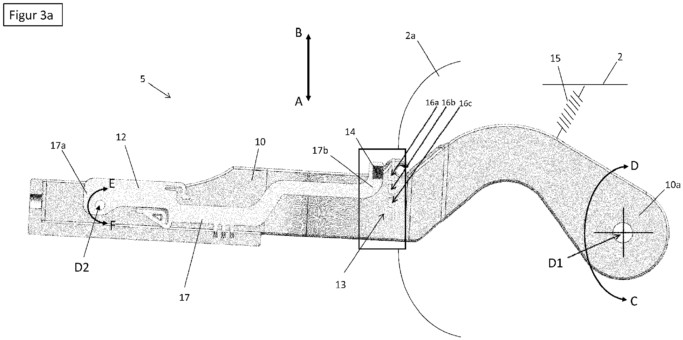

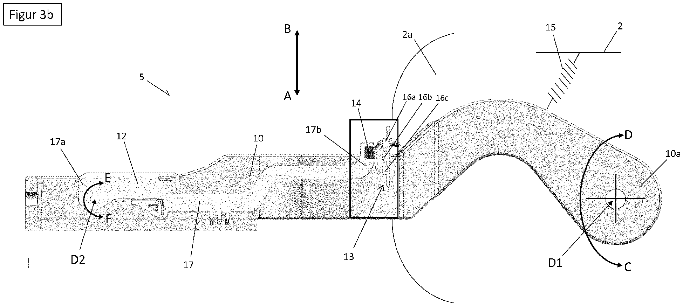

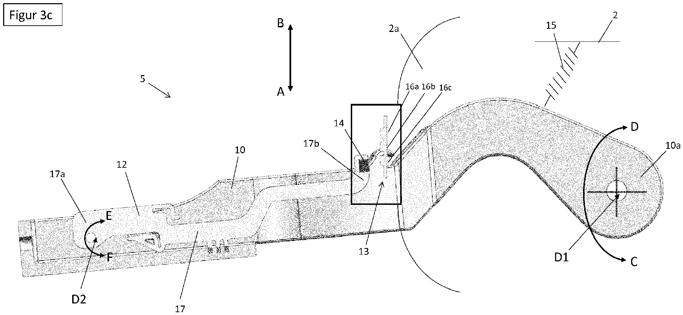

In den Figuren 3a bis 3c ist die erfindungsgemäße Handgriffvorrichtung 5 in Form eines zweiten Ausführungsbeispiels dargestellt. Die Handgriffvorrichtung 5 gemäß dem zweiten Ausführungsbeispiel enthält dabei im Wesentlichen ein Hebelelement 10, ein Griffstück 11, ein Aktivierungselement 12, eine Sensoreinrichtung 13 sowie einen Signalgeber 14.
Wie in den Figuren 3a bis 3c erkennbar, ist im Gegensatz zu der Handgriffvorrichtung 5 gemäß dem ersten Ausführungsbeispiel bei dem zweiten Ausführungsbeispiel ist das Aktivierungselement 12 und der Signalgeber 14 an einem Verbindungselement 17 positioniert.

Das Verbindungselement 17 ist im Wesentlichen in länglicher Form ausgestaltet und weist ein erstes und zweites Ende 17a, 17b auf. Das Aktivierungselement 12 ist an dem ersten Ende 17a und der Signalgeber 14 ist an dem zweiten Ende 17b des Verbindungselements 17 positioniert.

Zusätzlich ist an dem ersten Ende 17a des Verbindungselements 17 ein Drehlager vorgesehen, sodass das Verbindungselement 17 um einen zweiten Drehpunkt D2 in Drehrichtung E oder F geschwenkt werden kann. Durch Ausüben einer Kraft in Richtung A auf das Aktivierungselement 12 wird das Verbindungselement 17 um den Drehpunkt D2 in Drehrichtung E geschwenkt bzw. gedreht.

Wenn das Verbindungselement 17 um den Drehpunkt D2 in Drehrichtung E geschwenkt, bewegt sich der an dem zweiten Ende positionierte Signalgeber 14 in Richtung A. Der als Magnet ausgestaltete Signalgeber 14 wird damit an den drei Hall-Sensoren 16a, 16b, 16c der Sensoreinrichtung 13 vorbeigeführt.

Wie bereist vorstehend erwähnt erfasst die Sensoreinrichtung 13 die Positionierung des als Magnet ausgestalteten Signalgebers 14. Über die Positionierung des Signalgebers 14 relativ zu der Sensoreinrichtung 13 kann der Winkel der Handgriffvorrichtung 5 und die Kraft ermittelt werden, mit der die Handgriffvorrichtung 5 in Richtung A gedrückt wird. Wie ebenfalls bereist vorstehend erwähnt wird die Drehzahl des Antriebs 3 und damit die Abgabe der Schlagenergie von der Übertragungseinrichtung 6 auf das Werkzeug 9 in Abhängigkeit der Position des Signalgebers 14 bzw. der Position des Hebelelements 10 zu der Sensoreinrichtung 13 bzw. zu dem Gehäuse 2 der Werkzeugmaschine 1 eingestellt.

Wenn keine Kraft bzw. kein Druck mehr in Richtung A auf das Aktivierungselement 12 mehr ausgeübt wird, bewegt sich mit Hilfe eines zweiten Federelements das Aktivierungselement 12 in Richtung B wieder in die Ausgangsposition. Das Verbindungselement 17 wird mit Hilfe des zweiten Federelements um den Drehpunkt D2 wieder in Drehrichtung F geschwenkt. Das zweite Federelement ist in den Figuren nicht gezeigt.

Gemäß einer alternativen Ausgestaltungsform können auch mehr oder weniger als drei Hall-Sensoren vorgesehen sein. Entsprechend einer weiteren alternativen Ausgestaltungsform können anstelle der Hall-Sensoren 16a, 16b, 16c auch ein einziger oder mehrere 3D-Sensoren, TOF-Kameras (= Time Of Flight Kameras) und/oder PMD-Sensoren (= Photomischdetektoren) verwendet werden.

### Bezugszeichenliste

- 1: Werkzeugmaschine
- 2: Gehäuse
- 2a: erste Seite des Gehäuses
- 2b: zweite Seite des Gehäuses
- 3: Antrieb
- 4: Steuerungseinrichtung
- 5: Handgriffvorrichtung
- 6: Übertragungseinrichtung
- 7: Energieversorgungseinrichtung
- 8: Werkzeugaufnahme
- 9: Werkzeug
- 10: Hebelelement
- 10a: erstes Ende des Hebelelements
- 10b: zweites Ende des Hebelelements
- 10c: Oberseite des Hebelelements
- 10d: Unterseite des Hebelelements
- 11: Griffstück
- 12: Aktivierungselement
- 13: Sensoreinrichtung
- 14: Signalgeber
- 15: erstes Federelement
- 16a: erster Hall-Sensor
- 16b: zweiter Hall-Sensor
- 16c: dritter Hall-Sensor
- 17: Verbindungselement
- 17a: erstes Ende des Verbindungselements
- 17b: zweites Ende des Verbindungselements

## Patentansprüche

1. Handgriffvorrichtung (5) an einer Werkzeugmaschine (1), insbesondere Meißelhammer, mit einem Antrieb (3), einer Steuerungseinrichtung (4), einer Übertragungseinrichtung (6), wobei die Handgriffvorrichtung (5) ein Hebelelement (10) enthält, welches relativ zu einem Gehäuse (2) der Werkzeugmaschine (1) schwenkbar ist,
**dadurch gekennzeichnet, dass** das Hebelelement (10) durch Ausüben einer Kraft in eine Richtung (A) relativ zu dem Gehäuse (2) der Werkzeugmaschine (1) reversibel bewegbar ist und eine Sensoreinrichtung (13) enthalten ist zum Erfassen wenigstens einer ersten oder zweiten Position des Hebelelements (10) relativ zu dem Gehäuse (2) der Werkzeugmaschine (1), wobei eine erste Drehzahl für den Antrieb (3) eingestellt wird, wenn die erste Position des Hebelelements (10) relativ zu dem Gehäuse (2) der Werkzeugmaschine (1) erfasst wird und eine zweite Drehzahl für den Antrieb (3) eingestellt wird, wenn die zweite Position des Hebelelements (10) relativ zu dem Gehäuse (2) der Werkzeugmaschine (1) erfasst wird.

2. Handgriffvorrichtung (5) nach Anspruch 1,
**dadurch gekennzeichnet, dass** das Hebelelement (10) ein Signalgeber (14) mit wenigstens einem Magneten enthält und die Sensoreinrichtung (13) wenigstens einen ersten sowie zweiten Hall-Sensor (16a, 16b) zum Erfassen des wenigstens einen Magneten enthält, wobei der Signalgeber (14) relativ zu der Sensoreinrichtung (13) reversibel bewegbar ist.
